(19) Europäisches Patentamt

European Patent Office

Office européen des brevets

(11) **EP 0 930 702 B1**

(12) **EUROPEAN PATENT SPECIFICATION**

(45) Date of publication and mention
of the grant of the patent:
**09.07.2003 Bulletin 2003/28**

(51) Int Cl.⁷: **H03H 9/02**

(21) Application number: **99108152.2**

(22) Date of filing: **23.12.1994**

(54) **Orientational material and surface acoustic wave device**

Orientierbares Material und Oberflächenwellenanordnung

Matériau orientable et dispositif à ondes acoustiques de surface

(84) Designated Contracting States:
**DE FR GB NL SE**

(30) Priority: **25.03.1994 JP 7988394**
**27.05.1994 JP 11553894**

(43) Date of publication of application:
**21.07.1999 Bulletin 1999/29**

(62) Document number(s) of the earlier application(s) in
accordance with Art. 76 EPC:
**94120599.9 / 0 674 386**

(73) Proprietor: **SUMITOMO ELECTRIC INDUSTRIES,
LTD.**
**Osaka-shi, Osaka 541 (JP)**

(72) Inventors:
• **Hachigo, Akihiro Sumitomo Electric Ind. Ltd.
Itami-shi, Hyogo 664 (JP)**
• **Nakahata, Hideaki Sumitomo Electric Ind. Ltd.
Itami-shi, Hyogo 664 (JP)**
• **Higaki, Kenjiro Sumitomo Electric Ind. Ltd.
Itami-shi, Hyogo 664 (JP)**
• **Fujii, Satoshi Sumitomo Electric Ind. Ltd.
Itami-shi, Hyogo 664 (JP)**
• **Shikata, Shin-ichi Sumitomo Electric Ind. Ltd.
Itami-shi, Hyogo 664 (JP)**
• **Tanabe, Keiichiro, Sumitomo Electric Ind. Ltd.
Itami-shi, Hyogo 664-0016 (JP)**

(74) Representative:
**GROSSE BOCKHORNI SCHUMACHER**
**Patent- und Rechtsanwälte**
**Forstenrieder Allee 59**
**81476 München (DE)**

(56) References cited:
**EP-A- 0 282 075        EP-A- 0 587 068**

• **PATENT ABSTRACTS OF JAPAN vol. 017, no.
434 (E-1412), 11 August 1993 (1993-08-11) & JP
05 090888 A (SUMITOMO ELECTRIC IND LTD), 9
April 1993 (1993-04-09)**
• **TAKADA S ET AL: "Optical waveguides of
single-crystal LiNbO/sub 3/ film deposited by r.f.
sputtering" APPLIED PHYSICS LETTERS, 15
MAY 1974, USA, vol. 24, no. 10, pages 490-492,
XP000861780 ISSN: 0003-6951**

**Description**

BACKGROUND OF THE INVENTION

Field of the Invention

The present invention relates to an orientational material or substrate (i.e., a material comprising diamond with a surface of specific orientational diamond) which may suitably be used in a variety of devices such as dynamical (or mechanical), electric, electronic and optical devices utilizing diamond, and more particularly, to an orientational material or substrate comprising diamond and a layer comprising another substance disposed on a surface of specific orientational diamond provided by the diamond, and a surface acoustic wave device (hereinafter, referred to as "SAW device") utilizing the orientational substrate. Such a SAW device may suitably be used for an electric, electronic or optical device such as high-frequency filter.

Related Background Art

Diamond has a maximum acoustic propagation velocity among all of the substances present on the earth, and has a high heat conductivity and a band gap energy of 5.5 eV, which is very high as compared with those of known semiconductor substances. In addition, diamond is transparent with respect to light having a wavelength ranging from a near-ultraviolet region to a near-infrared region. Accordingly, it is expected that diamond can improve operating characteristic and/or can widen operating range or latitude in various technical or scientific fields such as acoustic, surface acoustic wave, optical, and semiconductor fields. From such a viewpoint, diamond is used in a variety of devices utilizing the dynamical, electric, electronic and/or optical characteristic of diamond. Specific examples of such a device utilizing diamond may include a SAW device which may suitably be used for a high-frequency filter, etc.

Heretofore, as the SAW device, there is known one having a multilayered structure comprising a diamond thin film and a combination of an electrode and a piezoelectric substance disposed on the diamond thin film, as shown in Japanese Patent Publication (KOKOKU) No. 38874/1979 (i.e., Sho 54-38874) and Japanese Laid-Open Patent Application (KOKAI) No. 62911/1989 (i.e., Sho 64-62911).

$LiNbO_3$ as one of piezoelectric substances is a ferroelectric substance, and has various features such that it has a high Curie temperature, a large birefringence, a large piezoelectric effect, good acousto-optical characteristic, and a large electro-optical effect. Accordingly, $LiNbO_3$ has been used for a SAW device, a modulation device, a switching device, a deflecting device, an optical waveguide, etc.

Heretofore, an $LiNbO_3$ wafer produced by a pulling process (such as Czochralski process) has been used for the above-mentioned usage. In addition, in recent years, the production of an $LiNbO_3$ thin film has been investigated for the purpose of fabricating a functional device, and the application of an $LiNbO_3$ thin film to various technical fields in which conventional bulk substrates of $LiNbO_3$ have heretofore been utilized.

Along with the recent advances in thin film formation technique, a monocrystalline (or single-crystalline) $LiNbO_3$ thin film has been formed by using a vapor deposition technique such as sputtering. A variety of applications of $LiNbO_3$ thin film have been investigated by using a multi-layer structure comprising an $LiNbO_3$ thin film and a base substance or substrate (such as $Al_2O_3$ and $LiTaO_3$) which has been used for the epitaxial growth of an $LiNbO_3$ thin film. Specific examples of the epitaxial growth of a monocrystalline $LiNbO_3$ thin film on a base substance of a different species may include: epitaxial growth on (0001) $Al_2O_3$ as described in Appl. Phys. Lett., vol. 24, pp. 490-492, (1974); and epitaxial growth on (0001) $LiTaO_3$ as described in Appl. Phys. Lett., vol. 26, pp. 8-10, (1978). For the purpose of obtaining an $LiNbO_3$ thin film having a better characteristic, a base substance having excellent physical properties has eagerly been sought.

On the other hand, as the SAW device, there has been known one having a structure of piezoelectric substance/diamond such as ZnO/diamond and $LiNbO_3$/diamond which utilizes a large acoustic propagation velocity of diamond, as disclosed in Japanese Laid-Open Patent Application No. 299309/1990(i.e., Hei 2-299309).

However, in the above-mentioned conventional SAW devices utilizing a diamond thin film, when a layer comprising a piezoelectric substance is formed on the diamond thin film, the resultant device utilizing diamond is liable to cause a large propagation loss of surface acoustic wave (hereinafter, referred to as "SAW").

SUMMARY OF THE INVENTION

An object of the present invention is to provide a novel orientational material or orientational substrate which may suitably be used for a device utilizing diamond such as SAW device.

Another object of the present invention is to provide a SAW device utilizing diamond, which may reduce propagation loss of SAW.

As a result of earnest study, the present inventors have found that, when a film comprising $LiNbO_3$ is disposed on a surface of diamond having a specific orientational property, a high axial orientational property of the $LiNbO_3$ film may easily be obtained. As a result of further study based on such a discovery, the present inventors have also found that the formation of a layer comprising $LiNbO_3$ having such a high axial orientational property on the above-mentioned surface of diamond having the specific orientational property is very effective in achieving the above-mentioned objects.

The material according to art related to the present invention is based on the above discovery and comprises: diamond, and an $LiNbO_3$ film disposed on a surface of (111) orientational diamond provided by the diamond.

Art related to present invention also provides a material comprising: monocrystalline diamond, and an $LiNbO_3$ film disposed on a surface of (111) orientational diamond provided by the monocrystalline diamond, the (001) plane of said $LiNbO_3$ film being parallel to the (111) plane of said monocrystalline diamond .

The present invention provides a material comprising: monocrystalline diamond, and an $LiNbO_3$ film disposed on a surface of (100) orientational diamond provided by the monocrystalline diamond, the (100) plane of said $LiNbO_3$ film being parallel to the (100) plane of said monocrystalline diamond .

The present invention further provides a surface acoustic wave device, comprising: a diamond layer, an $LiNbO_3$ film disposed on a surface of (111) orientational diamond provided by the diamond layer, and an interdigital transducer disposed on the $LiNbO_3$ film.

Art related to the present invention further provides a surface acoustic wave device, comprising: a diamond layer, an interdigital transducer disposed on a surface of (111) orientational diamond provided by the diamond layer, and an $LiNbO_3$ film disposed on the interdigital transducer.

Art related to the present invention further provides a surface acoustic wave device, comprising: a diamond layer, an interdigital transducer comprising semiconductive diamond and disposed on a surface of (111) orientational diamond provided by the diamond layer, and an $LiNbO_3$ film disposed on the interdigital transducer.

Art related to the present invention further provides a surface acoustic wave device, comprising: a diamond layer; an interdigital transducer comprising a conductive substance and disposed in an indentation of a surface of (111) orientational diamond provided by the diamond layer; and an $LiNbO_3$ film disposed on the interdigital transducer.

Art related to the present invention further provides a surface acoustic wave device, comprising: a diamond layer; a short-circuiting electrode disposed on a surface of (111) orientational diamond provided by the diamond layer; an $LiNbO_3$ film disposed on the short-circuiting electrode; and an interdigital transducer disposed on the $LiNbO_3$ film.

Art related to the present invention further provides a surface acoustic wave device, comprising: a diamond layer; an $LiNbO_3$ film disposed on a surface of (111) orientational diamond provided by the diamond layer; an upper layer comprising at least one substance selected from the group consisting of $SiO_2$, diamond and diamond-like carbon, which is disposed on the $LiNbO_3$ film; and an interdigital transducer disposed on the upper layer.

Art relating to the present invention further provides a surface acoustic wave device, comprising: a diamond layer; a short-circuiting electrode disposed on a surface of (111) orientational diamond provided by the diamond layer; an $LiNbO_3$ film disposed on the short-circuiting electrode; an upper layer comprising at least one substance selected from the group consisting of $SiO_2$, diamond, and diamond-like carbon, which is disposed on the $LiNbO_3$ film; and an interdigital transducer disposed on the upper layer.

Art related to the present invention further provides a surface acoustic wave device, comprising: a diamond layer; an $LiNbO_3$ film disposed on a surface of (111) orientational diamond provided by the diamond layer; a short-circuiting electrode disposed on the $LiNbO_3$ film; an upper layer comprising at least one substance selected from the group consisting of $SiO_2$, diamond, and diamond-like carbon, which is disposed on the short-circuiting electrode; and an interdigital transducer disposed on the upper layer.

Art related to the present invention further provides a surface acoustic wave device, comprising: a diamond layer; a first $LiNbO_3$ film disposed on a surface of (111) orientational diamond provided by the diamond layer; an interdigital transducer disposed on the first $LiNbO_3$ film; and a second $LiNbO_3$ film disposed on the interdigital transducer.

The term "surface of (111) orientational diamond" used herein has a meaning such that it includes both a surface of (111) plane of monocrystalline diamond, and a surface of polycrystalline diamond (or diamond film) having <111> orientational property. The monocrystalline diamond for providing the above-mentioned surface of (111) plane may comprise either of natural diamond crystal, high pressure-synthesized diamond crystal, and an epitaxial diamond film.

In addition, the term "surface of (100) orientational diamond" used herein has a meaning such that it includes both a surface of (100) plane of monocrystalline diamond, and a surface of polycrystalline diamond (or diamond film) having <100> orientational property. The monocrystalline diamond for providing the above-mentioned surface of (100) plane may comprise either of natural diamond crystal, high pressure-synthesized diamond crystal, and an epitaxial diamonds film.

In art relating to the present invention wherein an $LiNbO_3$ film is disposed on a surface of monocrystalline or polycrystalline (111) orientational diamond, there may be provided a higher c-axis orientational property as compared with that of an $LiNbO_3$ film formed on a surface of diamond having an orientational property other than (111). In the present invention, it is presumed that an $LiNbO_3$/diamond structure having a good piezoelectric property may be obtained on the basis of a combination of the crystal structure of $LiNbO_3$ and the above-mentioned high c-axis orientational property.

Accordingly, in a case where a SAW device is constituted by utilizing such a c-axis-oriented $LiNbO_3$ /diamond structure, the electromechanical coupling coefficient of the resultant device as an indication of conversion efficiency may be improved. In addition, in such a case, the surface flatness of the $LiNbO_3$ film is also improved and the c-axis thereof is aligned so that the film quality of the $LiNbO_3$ film is improved, and therefore the resultant SAW device may reduce the propagation loss.

According to the present inventors' investigation, the crystal structure of the above-mentioned $LiNbO_3$ film in the (001) plane (i.e., a plane perpendicular to c-axis) has an arrangement or configuration similar to that of the (111) plane of diamond, as compared with that of a plane of diamond having an orientation other than (111), and it is presumed that the crystal faces of the $LiNbO_3$ and diamond are liable co align or match with each other. Accordingly, in the present invention, it is presumed that the $LiNbO_3$ film formed on the (111) face of diamond may be caused to have a higher c-axis orientation.

Further, according to the present inventors' investigation, it is presumed that the above-mentioned $LiNbO_3$ film having a high c-axis orientation may have a good crystallinity, and the scattering of SAW at grain boundary may be reduced, whereby the propagation loss of SAW can be reduced.

In addition, according to the present inventors' experiments, it has been found that the surface of the $LiNbO_3$ thin film formed on the surface of diamond having the (111) orientational property has a higher surface flatness than that of an $LiNbO_3$ thin film formed on a surface of diamond having an orientational property other than (111). Also from such a viewpoint, it is presumed that the surface of the $LiNbO_3$ thin film formed on the surface of diamond having the (111) orientational property may reduce the scattering of SAW due to surface unevenness (i.e., indentations and protrusions of surface) as compared with that at the surface of an $LiNbO_3$ thin film formed on the a surface of diamond having an orientational property other than (111), and such reduction in the scattering of SAW may contribute to reduction in propagation loss.

On the other hand, in an embodiment of the present invention wherein an $LiNbO_3$ film is formed on a surface of (100) orientational diamond, there may be provided a higher a-axis orientational property as compared with that of an $LiNbO_3$ film formed on a surface of diamond having an orientational property other than (100). In such a case, it is also presumed that an $LiNbO_3$/diamond structure having a good piezoelectric property may be obtained on the basis of a combination of the crystal structure of $LiNbO_3$ and the above-mentioned high a-axis orientational property.

Further, in a case where a SAW device is constituted by utilizing such an a-axis-oriented $LiNbO_3$ /diamond structure, it is presumed that the electromechanical coupling coefficient of the resultant device may be improved, and the propagation loss in the resultant device may be reduced for a reason similar to that described in the above-mentioned case of the c-axis-oriented $LiNbO_3$ /diamond structure.

In a case where an optical waveguide is constituted by utilizing the orientational material or substrate according to the present invention, the grain boundary scattering may be reduced on the basis of the monocrystalline property or higher axis-oriented property, whereby the propagation loss can be reduced.

Further objects and advantages of the present invention will be apparent from the description of the preferred embodiments with the accompanying drawings.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

BRIEF DESCRIPTION OF THE DRAWINGS

Fig. 1 is a schematic sectional view showing an embodiment of the electrode arrangement (electrode arrangement A) usable in the SAW device according to the present invention.

Fig. 2 is a schematic sectional view showing another embodiment of the electrode arrangement (electrode arrangement C) usable in the SAW device according to the present invention.

Fig. 3 is a schematic sectional view showing a further embodiment of the electrode arrangement (electrode arrangement E) usable in the SAW device according to the present invention.

Fig. 4 is a schematic sectional view showing a further embodiment of the electrode arrangement (electrode arrangement F) usable in the SAW device according to the present invention.

Fig. 5 is a schematic plan view showing an example (single-type electrode) of the planar shape of an interdigital transducer (i.e., an electrode having a comb-like shape, hereinafter, referred to as "IDT") constituting a SAW device.

Fig. 6 is a schematic plan view showing another example (double-type electrode) of the planar shape of an IDT constituting a SAW device.

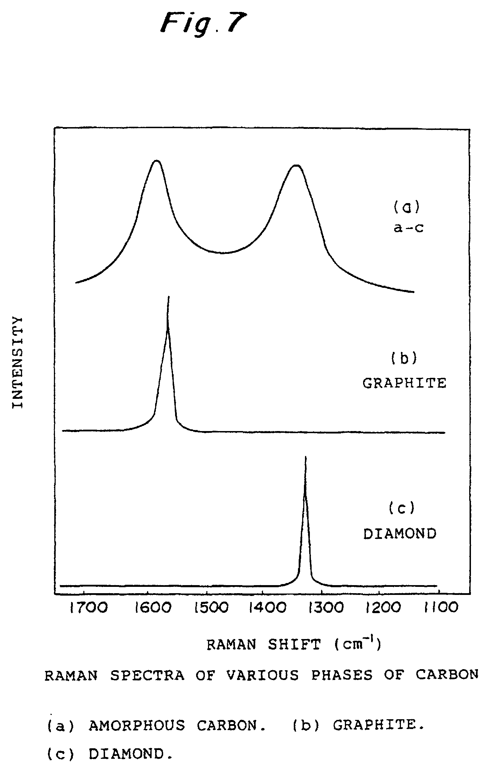

Fig. 7 is a graph showing typical Raman spectra of amorphous carbon (diamond-like carbon) film (curve $\underline{A}$), graphite (curve B), and diamond (curve C).

Fig. 8 is a schematic sectional view showing an example of the optical modulator utilizing an orientational substrate according to the present invention.

Fig. 9 is a graph showing X-ray diffraction data of the (001) $LiNbO_3$/(111) monocrystalline diamond structure obtained in Example 1 appearing hereinafter.

Fig. 10 is a view showing the results of RHEED analysis of the (001) $LiNbO_3$/(111) monocrystalline diamond structure obtained in Example 1 appearing hereinafter.

Fig. 11 is a view showing the results of simulation on the matching between (001) $LiNbO_3$ and (111) diamond.

Fig. 12 is a graph showing X-ray diffraction data of the (100) $LiNbO_3$/(100) monocrystalline diamond structure obtained in Example 2 appearing hereinafter.

Fig. 13 is a view showing the results of simulation on the matching between (100) $LiNbO_3$ and (100) diamond.

Fig. 14 is a schematic perspective view showing an interferometric optical waveguide modulator fabricated in Example 14 appearing hereinafter.

Fig. 15 is a graph showing a relationship between an applied voltage (abscissa) and the light intensity of an optical output (ordinate) in the interferometric optical waveguide modulator fabricated in Example 14 appearing hereinafter.

Fig. 16 is a graph showing the temperature characteristic of a diamond thermistor fabricated in Example 14 appearing hereinafter.

## DETAILED DESCRIPTION OF PREFERRED EMBODIMENTS

(Diamond)

In the present invention and art relating thereto, the crystallinity of diamond for providing a diamond surface on which an $LiNbO_3$ film is to be disposed, and the orientational property of such diamond may preferably be those constituting the following combinations in relation with the crystallinity (monocrystalline property and/or polycrystalline property) and the orientational property (such as c-axis orientational property or a-axis orientational property) of the $LiNbO_3$ film.

| <Diamond> | <LiNbO$_3$ Film> |
|---|---|
| <Example 1> | |
| Monocrystalline, (111) face | Monocrystalline, c-axis oriented |

(The (001) plane of $LiNbO_3$ is parallel to the (111) plane of the diamond.)

| <Diamond> | <LiNbO$_3$ Film> |
|---|---|
| <Example 2> | |
| Polycrystalline, face having (111) orientational property | Polycrystalline, c-axis oriented |

(The (001) plane of $LiNbO_3$ is parallel to the (111) plane of the diamond.)

| <Diamond> | <LiNbO$_3$ Film> |
|---|---|
| <Embodiment> | |
| Monocrystalline, (100) face | Monocrystalline, a-axis oriented |

(The (100) plane of $LiNbO_3$ is parallel to the (100) plane of the diamond.)

As the diamond for providing a surface of (111) orientational diamond, monocrystalline (or single-crystalline) diamond and/or polycrystalline diamond may be used. In other words, in the present invention, the term "surface of (111) orientational diamond" has a meaning such that it includes both a surface of (111) plane of monocrystalline diamond, and a surface of polycrystalline diamond (or polycrystalline diamond film) having <111> orientational property.

In art relating to the present invention wherein the diamond for providing the surface of (111) orientational diamond comprises monocrystalline diamond, it is easy to obtain diamond having little crystal (or lattice) defect due to good lattice matching. In such an embodiment, it is easier to obtain a SAW device with a small propagation loss.

On the other hand, in art relating to the present invention wherein the diamond for providing the surface of (111) orientational diamond comprises polycrystalline diamond, it is easy to use an inexpensive base substance on which the polycrystalline diamond is to be disposed or deposited.

In addition, in art related to the present invention wherein the diamond for providing the surface of (111) orientational diamond comprises an epitaxial (particularly, hetero-epitaxial) diamond layer, it is easy to use a base substance having a large area on which the epitaxial or hetero-epitaxial diamond is to be disposed or deposited. In such an embodiment, it is easy to obtain a SAW device with a relatively small propagation loss.

As long as the diamond for providing a surface on which the LiNbO$_3$ film is to be disposed has a specific orientational property as described above(i.e., (111) or (100) orientational property), the process or method for providing such a surface of diamond is not particularly limited. More specifically, for example, a surface of monocrystalline diamond having a specific orientation as such may be used as the surface of diamond having the specific orientational property. Alternatively, a diamond layer may be epitaxially grown on another substance (base substance), and the surface of the resultant diamond film may be used as the surface of diamond having the specific orientational property.

The shape (two-dimensional shape and/or three-dimensional shape) and size of the diamond for providing the surface of diamond with a specific orientational property are not particularly limited, but may be appropriately selected in accordance with the application or usage of the orientational material or substrate according to the present invention.

In the present invention, in a case where the diamond for providing the above-mentioned surface of diamond having a specific orientational property comprises a diamond film or layer, the process or method of growing the diamond (thin) film is not particularly limited. More specifically, the growth process to be used for such a purpose may appropriately be selected from known processes inclusive of: a CVD (Chemical Vapor Deposition) method, a microwave plasma CVD method, a PVD (Physical Vapor Deposition) method, a sputtering method, an ion plating method, a plasma jet method, a flame method, a hot filament method, etc.

The diamond for providing the surface of diamond having a specific orientational property may be either insulating diamond or semiconductive (or conductive) diamond. In the present invention, the above-mentioned "insulating diamond" is diamond having a volume resistivity exceeding 10$^6$ Ω·cm, and the above-mentioned "semiconductive diamond" is diamond having a volume resistivity of 10$^6$ Ω·cm or less.

The method of providing the semiconductive (or conductive) diamond is not particularly limited. For example, the semiconductive diamond may be provided by hydrogenation of diamond, doping of diamond with an impurity, or introduction of a lattice defect into diamond, etc.

In a case where the above-mentioned semiconductive diamond is used for an IDT of the SAW device according to the present invention, diamond having a volume resistivity of 10$^6$ Ω·cm or less can be used as the semiconductive diamond. In view of the characteristic of the SAW device, the volume resistivity of the semiconductive diamond may preferably be 10$^{-2}$ Ω·cm or less (more preferably 10$^{-4}$ Ω·cm or less).

(Orientational Property of Diamond)

As described above, according to the present inventors' investigation, when an LiNbO$_3$ film is formed on a surface of (111) orientational monocrystalline diamond, epitaxial diamond layer or polycrystalline diamond, the resultant LiNbO$_3$ film shows a highest orientational property.

In art related to the invention, the orientational property of the above-mentioned "(111) orientational diamond" may be evaluated on the basis of comparison between a diffraction intensity based on a (111) plane in diffraction intensity provided by X-ray diffraction, and a diffraction intensity based on the other plane (or planes). In such X-ray diffraction, for example, it is possible to use an ordinary technique utilizing Cu-Kα ray (1.54 Å (angstrom)) as monochromatic or homogeneous X-ray.

More specifically, the orientational property of (111) orientational diamond may be evaluated in the following manner.

Thus, in the diffraction intensities provided by X-ray diffraction of polycrystalline diamond, etc., the diffraction intensity based on a (111) plane and the diffraction intensity based on the other plane or planes (e.g., (220) and (400) planes) are measured. The thus measured diffraction intensity of the other plane is normalized in such a manner that the intensity of the (111) plane is "100" (i.e., relative intensities are determined with respect to the (111) plane intensity which is equal to 100). Then, a sum of the diffraction intensities based on the planes other than (111) plane is calculated with reference to the diffraction intensity of (111) plane (i.e., 100). In the present invention, the sum of the normalized diffraction intensities based on the planes other than (111) may preferably be 25 or less, in view of a good c-axis orientational property of an $LiNbO_3$ film to be formed on the surface of (111) orientational diamond. ($LiNbO_3$ film)

In the present invention, the $LiNbO_3$ film to be formed on the above-mentioned surface of diamond having a specific orientational property may be monocrystalline or polycrystalline. In the present invention, the crystallinity of the $LiNbO_3$ film may preferably be selected in combination with a diamond surface as described in the above-mentioned "Embodiment 1 to 3".

As the process or method for forming the $LiNbO_3$ film, any of known methods may be used without particular limitation. Specific examples of such a known method may include: sputtering, vapor-phase deposition (inclusive of vacuum evaporation), a CVD method, a laser annealing method, a MOCVD (Metal-Organic CVD) method, or an MBE (Molecular Beam Epitaxy) method.

The thickness of the $LiNbO_3$ film may appropriately be selected in accordance with the application or usage of the orientational material or substrate according to the present invention, and the thickness thereof is not particularly limited.

(Orientational Property of $LiNbO_3$ Film)

In the present invention, the orientational property of an $LiNbO_3$ film may be evaluated by, e.g., an X-ray rocking (curve) pattern method, as one of the methods of evaluating the orientational property of a crystal face or crystal plane. More specifically, the orientational property (in-plane orientational property) may be evaluated in the following manner.

(1) A sample to be measured is placed in a sample holder of an X-ray diffractometer.
(2) The plane orientation of a face to be evaluated is measured by using an X-ray diffraction pattern method utilizing the above-mentioned X-ray diffractometer.
(3) The θ-axis (corresponding to the rotation of the sample to be measured) and the 2θ-axis (corresponding to an X-ray counter of the X-ray diffractometer) are rotated and then fixed so that the θ- and 2θ-axes provide a maximum output value in orientation of the face to be evaluated. In the case of an $LiNbO_3$ film of which c-axis is oriented perpendicularly to a base substance on which the $LiNbO_3$ film is to be disposed, 2θ is 38.9° and θ is 19.5°. On the other hand, in the case of an $LiNbO_3$ film of which a-axis is oriented perpendicularly to a base substance on which the $LiNbO_3$ film is to be dispcsed, 2θ is 62.4° and θ is 31.2°.
(4) Only the sample (i.e., the θ-axis) is rotated and a rocking curve is measured.
(5) The thus obtained rocking curve is regarded as one having a Gaussian distribution, and a standard deviation σ thereof is determined.

As the standard deviation σ of the rocking curve measured as described above is decreased, it indicates a higher orientational property of the sample to be evaluated. The deviation σ may preferably be 5 or less (more preferably, 4 or less) in the orientational material or substrate, or SAW device according to the present invention.

(Electrode Arrangement)

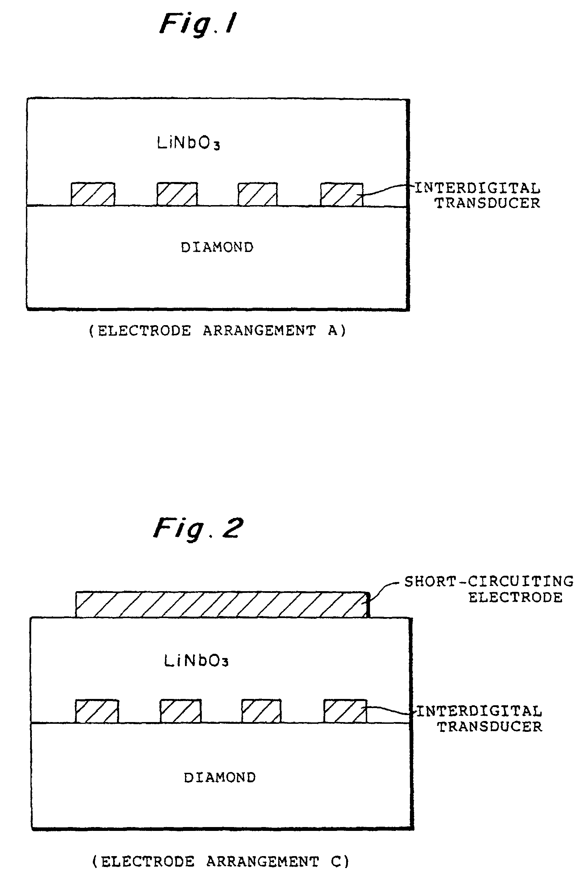

In the SAW device according to the present invention, it is preferred to use electrode arrangements of IDT (in addition, a short-circuiting electrode, as desired) as shown in the schematic sectional views of Figs. 1 to 4.

In the arrangement (electrode arrangement A) shown in Fig. 1, the SAW device comprises diamond, an IDT disposed on the diamond, and an $LiNbO_3$ layer disposed on the IDT. The arrangement (electrode arrangement C) shown in Fig. 2 further comprises a short-circuiting electrode on the $LiNbO_3$ layer constituting the above-mentioned "electrode arrangement A".

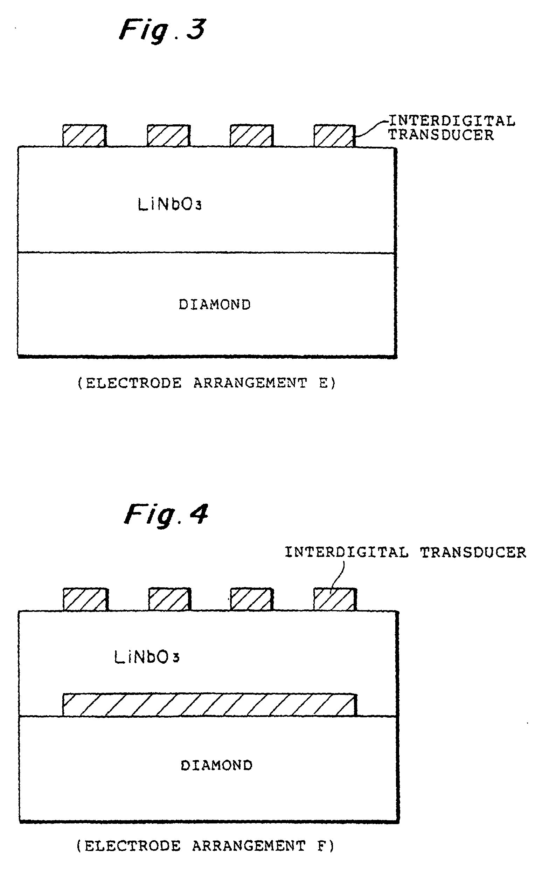

In the arrangement (electrode arrangement E) shown in Fig. 3, the SAW device comprises diamond, an $LiNbO_3$ layer disposed on the diamond, and an IDT disposed on the $LiNbO_3$ layer. The arrangement (electrode arrangement F) shown in Fig. 4 further comprises a short-circuiting electrode disposed between the diamond and the $LiNbO_3$ layer constituting the above-mentioned "electrode arrangement E".

(IDT)

In the SAW device according to the present invention, the substance to be used for the IDT is not particularly limited as long as it comprises an electroconductive substance. In view of processability or workability and production cost, Al (aluminum) may particularly preferably be used as the substance constituting the IDT.

The thickness of the IDT is not particularly limited, as long as it functions as an IDT of a SAW device. In general, the thickness of the IDT may preferably be in the range of about 100 to 3,000 Å (more preferably, about 100 to 500 Å). When the thickness of the IDT is less than 100 Å, the electrode resistivity is increased to cause an increase in loss. On the other hand, when the thickness of the IDT exceeds 3,000 Å, it provides a considerable mass addition effect which is liable to cause reflection of SAW due to the thickness and height of the electrode, and it becomes difficult to obtain a desired SAW characteristic of the SAW device.

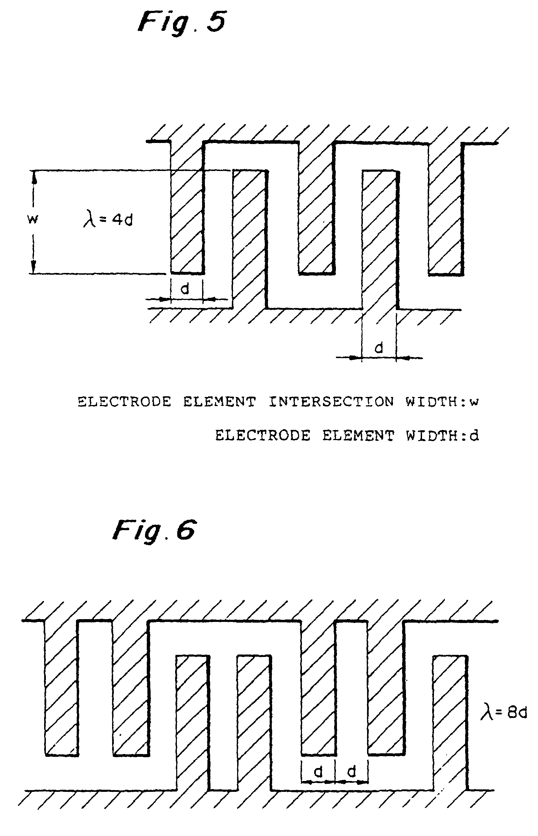

The planar or two-dimensional shape of the IDT is not particularly limited, as long as it may function as an IDT of the SAW device. As the IDT, a so-called "single-type" electrode as shown in the schematic plan view of Fig. 5 or a so-called "double-type" electrode as shown in the schematic plan view of Fig. 6 may preferably be used.

As desired, the above-mentioned IDT may be embedded in a surface (e.g., a surface of diamond having a specific orientational property such as (111)) on which the IDT is to be disposed. More specifically, for example, a recessed or indented portion having a shape such as groove may be formed (or a predetermined surface having a recessed portion may be formed in advance), and at least a part of (i.e., all or a part of) a conductive substance, such as Al, constituting the IDT may be embedded in the recessed portion. When all or a part of the IDT is embedded in this manner, for example, the surface level or height of the IDT can be made substantially equal to the surface on which the IDT is to be formed. As a result, an influence of SAW reflection caused by the thickness of the IDT can be reduced.

(Short-Circuiting Electrode)

In the SAW device according to art related to the present invention, the short-circuiting electrode to be formed as desired, is an electrode having a function of providing an equipotential state to an electric field so as to change the SAW characteristic of the device. This electrode may preferably comprise a (thin) film of a metal such as Al, Au and Al-Cu. Since the short-circuiting electrode has a function different from that of the IDT as described above, the substance constituting the short-circuiting electrode is not necessarily the same as that of the IDT.

The thickness of the short-circuiting electrode is not particularly limited as long as it may function as a short-circuiting electrode of a SAW device. The thickness of the short-circuiting electrode may preferably be in the range of about 100 to 3,000 Å (more preferably, about 100 to 500 Å). When the thickness is less than 100 Å, it is difficult to obtain an equipotential state as described above. On the other hand, when the thickness exceeds 3,000 Å, it is liable to affect the reflection of SAW.

For example, the short-circuiting electrode may preferably has a two-dimensional shape as a "solid electrode" having an area substantially equal to that of the IDT to be used in combination therewith.

(Upper Layer of $SiO_2$, etc.)

In the SAW device according to art related to the present invention, a layer (upper layer) comprising at least one substance selected from the group consisting of $SiO_2$, diamond, and diamond-like carbon may be formed, as desired. Such a layer of $SiO_2$, etc., may also have a function of a protective layer.

When an $SiO_2$ (thin) film is formed on the $LiNbO_3$ film, the temperature coefficient may be reduced, and/or the electromechanical coupling coefficient as an indication of efficiency may easily be increased.

On the other hand, when a diamond thin film or diamond-like carbon film is formed on the $LiNbO_3$ film, the propagation velocity can be increased, and at the same time, a large electromechanical coupling coefficient can easily be obtained.

(Diamond-Like Carbon)

Diamond-like carbon (DLC) constituting the above diamond-like carbon film is an amorphous material having a high hardness. The diamond-like carbon has an excellent stability and comprises carbon atoms which are the same as those constituting diamond. Accordingly, the diamond-like carbon has an advantage such that atomic or elemental diffusion therefrom to diamond, or a reaction thereof with diamond is substantially negligible. For this reason, the diamond-like carbon may suitably be used as an insulating substance for forming an upper layer (e.g., insulating film) to be formed in the SAW device, as desired.

The diamond-like carbon (sometimes called as "i-carbon" or "amorphous carbon") to be used herein is a substance having the following properties.

(1) In general, diamond-like carbon contains hydrogen atoms in addition to carbon atoms. In this case, the number of moles of hydrogen may preferably be smaller than the number of moles of carbon.

(2) The crystalline state of diamond-like carbon is amorphous. The diamond-like carbon can be discriminated from diamond or graphite, e.g., by use of Raman spectroscopy. Fig. 3 shows typical spectra of diamond-like carbon or amorphous carbon (curve A), graphite (curve B), and diamond (curve C). As shown in Fig. 3, the Raman spectrum of diamond (curve C) has a sharp peak at 1,332 cm$^{-1}$ (based on sp$^3$ C-C bond), and the Raman spectrum of graphite (curve B) has a sharp peak at 1,580 cm$^{-1}$ (based on sp$^2$ C-C bond). On the other hand, the Raman spectrum of diamond-like carbon (curve A) has broad peaks at 1,360 cm$^{-1}$ and 1,600 cm$^{-1}$.

(3) The diamond-like carbon has a higher hardness than those of general metals. More specifically, the diamond-like carbon to be used in the present invention may preferably has a Vickers hardness Hv of about 1,000 to 5,000, while diamond generally has a Vickers hardness Hv of about 10,000.

(4) The diamond-like carbon is an electrically insulating substance.

(5) The diamond-like carbon has a light-transmitting property.

A diamond-like carbon film having the above properties may be formed by a vapor-phase process such as plasma CVD, ion beam deposition, or sputtering similarly as in the synthesis of diamond. More specifically, the diamond-like carbon can be obtained by decreasing the temperature of a substrate on which the diamond-like carbon is to be deposited (e.g., a temperature of the substrate of about 100°C) under the CVD conditions which are the same as those for diamond formation (with respect to further details of diamond-like carbon, e.g., a paper entitled "Diamond-Like Carbon Thin Films", written by Akio Hiraki and Hiroshi Kawarada, "TANSO (Carbon)", 1987 (No. 128), pp. 41-49 (published by Nihon Tanso Gakkai) may be referred to).

(Application or Usage of Orientational Material)

The orientational material or substrate according to the present invention and art related thereto may be applied to a variety of devices having or utilizing an LiNbO$_3$/diamond structure. More specifically, the orientational material or substrate according to the Embodiments 1 to 3 as described above may preferably be applied in the following manner.

| <Diamond> | <LiNbO$_3$ Film> |
|---|---|
| <Example 1> | |
| Monocrystalline, (111) face | Monocrystalline, c-axis oriented |

(The (001) plane of LiNbO$_3$ is parallel to the (111) plane of the diamond.)

Application or usage: optical waveguide, optical branching device, switch, SAW device, etc.

| <Diamond> | <LiNbO$_3$ Film> |
|---|---|
| <Example 2> | |
| Polycrystalline, face having (111) orientational property | Polycrystalline, c-axi oriented |

(The (001) plane of LiNbO$_3$ is parallel to the (111) plane of the diamond.)

Application or usage: SAW device, etc.

| <Diamond> | <LiNbO$_3$ Film> |
|---|---|
| <Embodiment> | |
| Monocrystalline, (100) face | Monocrystalline, a-axis oriented |

(The (100) plane of LiNbO$_3$ is parallel to the (100) plane of the diamond.)

Application or usage: optical waveguide, optical branching device, switch, SAW device, etc.

(Example of Application as Optical Waveguide)

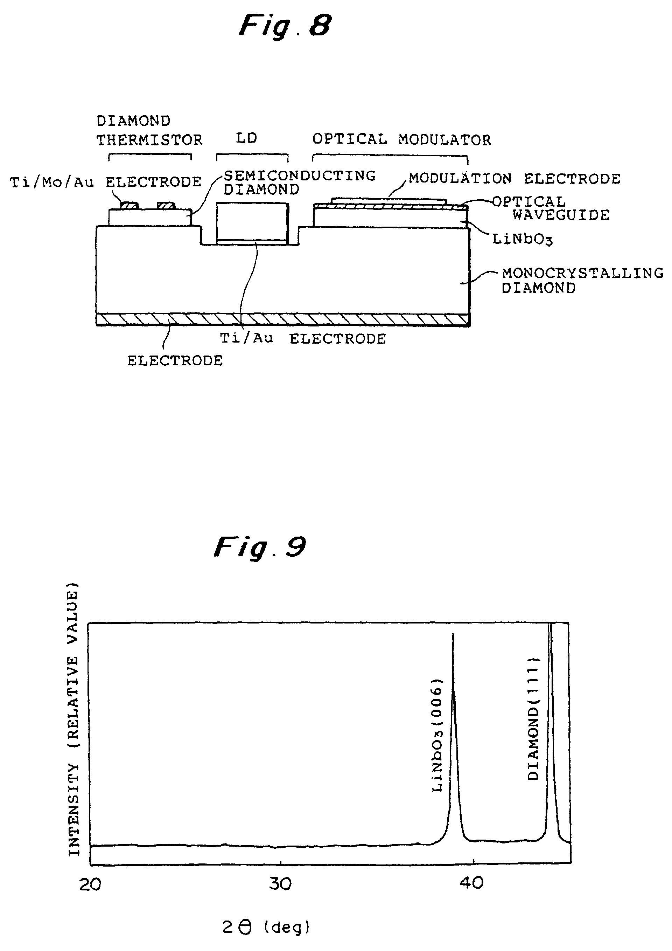

Hereinbelow, an application of the orientational substrate according to the present invention as an optical waveguide will be described with reference to the schematic sectional view of Fig. 8.

Referring to Fig. 8, first, an LiNbO$_3$ film is grown on diamond. At two ends of the resultant LiNbO$_3$ film, a

diamond thermistor and an LD (Laser Diode) are respectively disposed thereby to constitute an external optical modulator on the LiNbO$_3$ film. In such an embodiment, since the respective devices are formed on a diamond heat sink having a high heat conductivity, the resultant optical modulator can be caused to have excellent thermal stability. At this time, in view of reduction in the light propagation loss, the LiNbO$_3$ film to be formed on the diamond may preferably be monocrystalline.

More specifically, the above-mentioned preferred LiNbO$_3$ film can be formed by epitaxially growing an LiNbO$_3$ (001) film on a surface of (111) plane of high-pressure synthesized monocrystalline diamond. In order to form an optical waveguide on such an LiNbO$_3$ film, for example, a proton exchange method may preferably be used. The proton exchange method is a kind of method of forming an optical waveguide and may suitably be used for LiNbO$_3$, etc.

When the proton exchange method is used, for example, a waveguide is formed on a surface of the LiNbO$_3$ film by use of photolithography, and thereafter the LiNbO$_3$ film is caused to contact a proton exchange reagent such as benzoic acid or pyrophosphoric acid so as to exchange Li in the LiNbO$_3$ for H (proton) in the acid (proton exchange reagent). As a result, in a portion at which the proton exchange has occurred, the refractive index may be increased (with respect to further details of the proton exchange method, e.g., Hiroshi Nishihara et al., "Optical Integrated Circuit", pp. 167-170, Ohm Sha (Tokyo, JAPAN), 1990 may be referred to).

Other examples of the method of forming a waveguide may include: a method of forming a buried- or embedded- type waveguide; a method of forming a projecting ridge-type waveguide; and a method of forming a loaded-type waveguide, wherein a decrease in refractive index caused by the load of a metal electrode is utilized, and a portion of LiNbO$_3$ film having no electrode disposed thereon is caused to constitute a waveguide, .

As the method of forming a waveguide which may suitably be used in combination with a buried-type optical modulator, a Ti diffusion method, a proton exchange method, or the like is known. When the proton exchange method is used for such a purpose, a larger refractive index difference can be obtained and optical damage can be reduced, as compared with those provided by the Ti diffusion method. Accordingly, in such a case, a low-loss type waveguide can easily be formed.

A semiconductor device such as semiconductor laser and thermistor generates heat during the use thereof for a long period of time, and the operating characteristic of the semiconductor device can be changed due to the resultant heat. Particularly, in a case where a semiconductor laser is used for communication, etc., variation in the frequency for the communication is liable to pose a problem such as occurrence of crosstalk and increase in noise. In view of prevention of these problems, in general, the semiconductor layer may preferably be disposed on a heat sink to dissipate heat. When a semiconductor laser is disposed on diamond having the highest heat conductivity and a change in the heat is subjected to feed back control by using a thermistor, etc., so as to make the temperature or temperature change constant, it is possible to form an optical modulator having a preferred stability.

Hereinbelow, the present invention and art related thereto will be described in more detail with reference to specific Examples.

Example 1

An LiNbO$_3$ film was formed on each of Ia-type natural diamond having a (111) plane orientation and Ib-type high-pressure synthesized diamond having a (111) plane orientation by using an RF magnetron sputtering method.

<RF Magnetron Sputtering Conditions>

Pressure: 0.015 Torr
Substrate Temperature: 600°C
Ar : O$_2$ = 1 : 2
RF Power: 50 W
Film Thickness: about 0.7 $\mu$m
Target: Li : Nb = 3 : 2 sintered product

The thus formed two LiNbO$_3$ films were examined by using an X-ray diffraction apparatus. No diffraction other than the diffraction based on (006) was observed in each of the above-mentioned two LiNbO$_3$ films. In other words, it was confirmed that in each of the two LiNbO$_3$ films, the (111) plane of the diamond was parallel to the (001) plane of the LiNbO$_3$ film. The results of the X-ray diffraction are shown in the graph of Fig. 9.

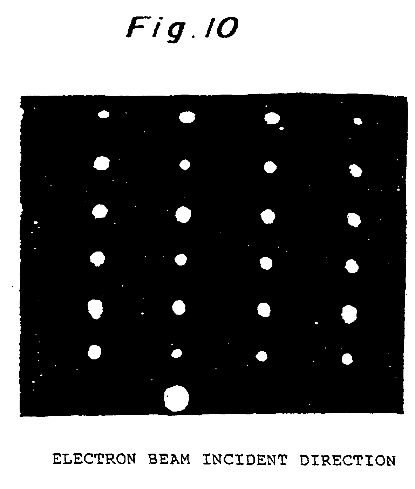

The LiNbO$_3$ film formed on the Ib-type high-pressure monocrystalline diamond can be analyzed by an RHEED method (Reflection High-Energy Electron Diffraction) wherein an electron beam is incident in a direction of [$\bar{1}$ 10] . Fig. 10 shows an example of photograph (duplicate) showing results of RHEED analysis. RHEED is a technique of electron beam diffraction, i.e., a method wherein a diffraction pattern of electron based on scattering on the surface of a substance is observed by using a fluorescent screen disposed in the rear side. Epitaxial growth of an $LiNbO_3$ film can be confirmed on the basis of a pattern entirely consisting of spots as shown in Fig. 10.

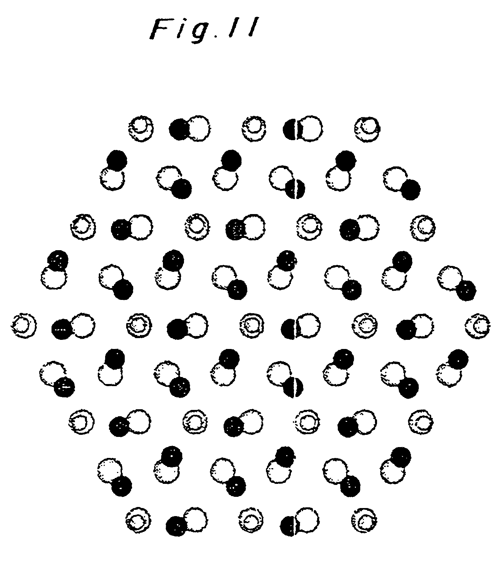

Fig. 11 shows results of a simulation and represents a state of matching between the (111) plane of monocrystalline diamond and the (001) plane of $LiNbO_3$ which has been provided by using a commercially available program "MOLGRAPH" (available from DAIKIN Industries, Ltd., JAPAN). Fig. 11 shows a state wherein monocrystalline diamond is placed in the upper side. In Fig. 11, a white circle denotes a C atom; a black circle denotes an O atom; and a gray circle denotes an Li atom. As shown in Fig. 11, the ratio between the distance between the Li atoms in the lattice, and the distance between C atoms in the lattice is about 2 : 1, and each of the C atoms is matched or aligned with every other atom of the Li atoms. On the other hand, each of the O atoms is positioned closely to each of the C atoms.

Example 2

An $LiNbO_3$ film was formed on each of Ia-type natural diamond having a (100) plane orientation and Ib-type high-pressure synthesized diamond having a (100) plane orientation by using an RF magnetron sputtering method.

<RF Magnetron Sputtering Conditions>

    Pressure: 0.015 Torr
    Substrate Temperature: 650°C
    Ar : $O_2$ = 2 : 3
    RF Power: 100 W
    Film Thickness: about 0.7 μm
    Target: Li : Nb = 3 : 2 sintered product

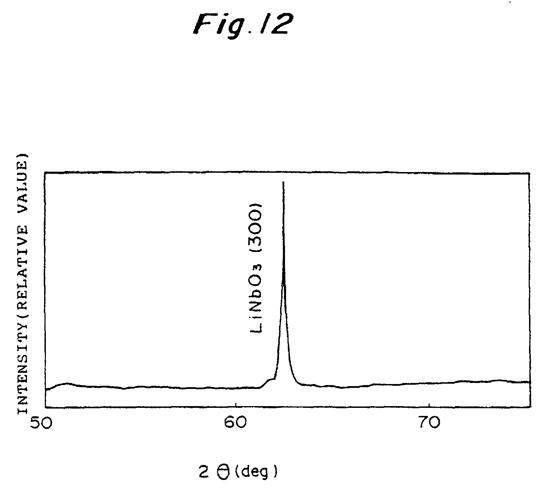

Each of the above-mentioned two $LiNbO_3$ films was examined by using an X-ray diffraction apparatus. No diffraction based on orientations other than (300) was observed in each of the $LiNbO_3$ films. In other words, it was confirmed that the (100) plane of each of the above diamonds was parallel to the (100) plane of the corresponding $LiNbO_3$ film. The results of the above X-ray diffraction are shown in the graph of Fig. 12.

When each of the resultant $LiNbO_3$ films formed on the diamond was analyzed by an RHEED method wherein an electron beam is incident in the direction of [1-01]), a pattern entirely consisting of spots was obtained similarly as in Example 1. In other words, it was confirmed that the above $LiNbO_3$ films were epitaxially grown films.

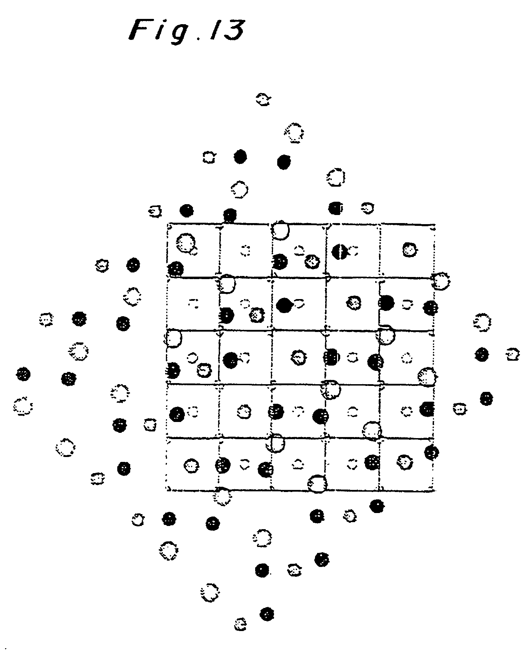

Fig. 13 shows results of a simulation representing a state of matching between the (100) plane of monocrystalline diamond and the (100) plane of $LiNbO_3$ which has been provided by using a commercially available program "MOLGRAPH" (available from DAIKIN Industries, Ltd., JAPAN). Fig. 13 shows a state wherein monocrystalline diamond is placed in the lower side. In Fig. 13, a smallest white circle denotes a C atom, and the C atom is positioned at each lattice point and at the center of the lattice.

In Fig. 13, a black circle denotes an O atom; and a gray circle denotes an Li atom. As shown in Fig. 13, the ratio between the distance between the Li atoms in the lattice, and the distance between C atoms in the lattice is about 2 : 1, similarly as in Fig. 11 described above. On the other hand, each of the O atoms is positioned closely to each of the C atoms.

Example 3

A diamond thin film (thickness: 15 μm) was epitaxially grown on each of high-pressure synthesized (100) monocrystalline diamond, (111) monocrystalline diamond, a surface of (100) Si, and a surface of (111) β-SiC, and the resultant diamond film surface was polished and flattened so as to provide a thickness of 13 μm. Thereafter, an $LiNbO_3$ film was then formed on each of the resultant diamond films. At this time, the conditions for the formation of the $LiNbO_3$ film were the same as those used in Example 2.

<Conditions for Diamond Film formation and Diamond Epitaxial Film formation on (100) Monocrystalline Diamond and (100) Si>

Microwave Plasma CVD

 Power: 300 W
 Pressure: 30 to 40 Torr
 $CH_4/H_2$ = 1 to 6 (%)

<Conditions for Epitaxial Film Formation on (111) Monocrystalline Diamond>

Microwave Plasma CVD

 Power: 300 W
 Pressure: 30 to 40 Torr
 $CH_4/H_2$ = 1 to 2 (%)

<Conditions for Hetero-Epitaxial Growth on SiC>

Microwave Plasma CVD Method

 Microwave Power: 900 W
 Pressure: 10 to 3 mTorr (10 to 3 x $10^{-3}$ Torr)
 $CH_4/H_2$ = 5/99.5
 Substrate Temperature: 800°C

 (A DC bias of -150 V was applied to the substrate side.)

Each of the four species of the $LiNbO_3$ films formed in the above-described manner was examined by using an X-ray diffraction apparatus. with respect to the $LiNbO_3$ films formed on the epitaxial diamond chin film on the (100) monocrystalline diamond and the (100) Si, a peak based on (300) diffraction was observed alone. In other words, it was confirmed that the (100) plane of each diamond was parallel to the (100) plane of the corresponding $LiNbO_3$ film.

With respect to the $LiNbO_3$ thin films formed on the diamond thin film on the (111) monocrystalline diamond and the (111) SiC, a peak based on the (006) X-ray diffraction was observed alone. In other words, it was confirmed that the (111) plane of each diamond was parallel to the (001) plane of the corresponding $LiNbO_3$ film.

In the RHEED observation, a pattern entirely consisting of spots was observed in each of the four species of $LiNbO_3$ thin films. Accordingly, it was found that each of these $LiNbO_3$ thin films was epitaxially grown on the corresponding epitaxial diamond thin film.

Example 4

(Comparison with Sapphire Substrate)

A 1.0-μm thick monocrystalline $LiNbO_3$ thin film was formed on each of c-cut sapphire and (111) monocrystalline diamond. when each of the resultant $LiNbO_3$ thin films was examined by using X-ray diffraction, it was confirmed that both the $LiNbO_3$ thin films formed on the sapphire and diamond were $LiNbO_3$ epitaxial films having (001) orientation.

A 500-Å thick Al thin film was vapor-deposited on each of the resultant two species of monocrystalline $LiNbO_3$ thin films, and then subjected to photolithography to form an IDT (double-type electrode as shown in Fig. 6; d = 1 μm; number of input-output electrode element pairs: 40; distance between centers of input and output electrodes: 640 μm) each having a period of 8 μm, whereby SAW devices were obtained respectively.

The frequency characteristic of each of the resultant SAW devices was evaluated by using a commercially available network analyzer (trade name: 8719A, available from Yokogawa-Hewlett-Packard (YHP) K.K.). The operating frequency of the SAW device utilizing the sapphire substrate was 675 MHz, while the operating frequency of the SAW device utilizing the monocrystalline diamond substrate was 1.26 GHz. In other words, the SAW device having a structure comprising the LiNbO$_3$ epitaxial film having (001) orientation disposed on the (111) monocrystalline diamond had a higher operating frequency than that of the SAW device utilizing the sapphire substrate, even when an IDT having the same electrode width was used in each of the SAW devices.

Example 5

High-pressure synthesized monocrystalline diamond was cut in a direction so as to provide (110), (331), (112), and (111) plane orientations, and a 10,000-Å thick LiNbO$_3$ thin film was formed on each of the resultant diamond surfaces.

<LiNbO$_3$ Formation Conditions>

Pressure: 0.015 Torr
Substrate Temperature: 600°C
Ar : O$_2$: 1 : 2
RF Power: 50 W
Target: Li : Nb = 3 : 2 sintered product

When each of the resultant four species of LiNbO$_3$ films was analyzed by using X-ray diffraction and RHEED, it was found that the LiNbO$_3$ film formed on the monocrystalline diamond substrate having (111) plane orientation was an epitaxially grown LiNbO$_3$ film having (001) plane (c-axis orientation). On the other hand, it was found that each of the LiNbO$_3$ films respectively formed on the diamond substrates having a plane orientation other than (111) comprised a mixed film having (110) and (104) orientations in addition to the plane orientation corresponding to c-axis.
A 500-Å thick Al thin film was vapor-deposited on each of the above-mentioned four species of monocrystalline LiNbO$_3$ thin films, and then subjected to photolithography to form an IDT having a period of 8 μm, whereby SAW devices were fabricated. At this time, three species of IDTs having three different distances between the input and output electrodes as described below were formed as the above-mentioned IDT constituting the SAW device.

Electrode Element (teeth of comb-like shape): 40 pairs (double-type electrode, normal-type)
Electrode Element Width: 1.2 μm (Center Frequency: 1 GHz)
Electrode Element Intersection Width:
50 x Wavelength (wavelength: electrode width × 8) Distance between Centers of Input and Output Electrodes: 50 x wavelength, 80 x wavelength, 110 x wavelength

With respect to each of the thus prepared SAW devices, propagation loss and electromechanical coupling coefficient (K$^2$) as an indication of efficiency were evaluated by measuring the operating characteristics of the device by means of a commercially available network analyzer (trade name: 8719A, available from Yokogawa-Hewlett-Packard (YHP) K.K.). At this time, an insertion loss (IL) of propagation characteristic S21 as a measurement parameter was calculated, and conversion losses (TL1) and (TL2) as other measurement parameters were calculated from reflection characteristics S11 and S12, and the following propagation loss PL (dB):

$$PL\ (dB) = IL - TL1 - TL2 - 6$$

was calculated by using a bidirectional loss of 6 (dB) which is inherently provided in such an electrode arrangement or structure.
On the other hand, the electromechanical coupling coefficient (K$^2$) was obtained by measuring the radiation conductance (wherein the real part is denoted by "G") of the IDT by using the above network analyzer and calculated according to the following formula:

$$K^2 = (G/8) \cdot f_0 \cdot C \cdot N$$

(f$_0$: center frequency, C: total electrostatic capacitance of IDT, and N: number of element pairs constituting IDT).
Separately from the formation of the above SAW devices, an LiNbO$_3$ film having a (100) orientation was epitaxially grown on a (100) monocrystalline diamond substrate under the following conditions, and then an Al thin film was vapor-deposited on the resultant $LiNbO_3$ film and subjected to photolithography to form an IDT having a period of 8 μm in the same manner as described above, thereby to fabricate a SAW device.

With respect to the thus obtained SAW device, the propagation loss and electromechanical coupling coefficient were measured in the same manner as described above.

<Conditions for (100) $LiNbO_3$ Epitaxial Film Formation>

Pressure: 0.015 Torr
Substrate Temperature: 650°C
Ar : $O_2$: 2 : 3
RF Power: 100 W
Target: Li : Nb = 3 : 2 sintered product

The results of measurement of the propagation losses and electromechanical coupling coefficients are summarized in the following Table 1.

[Table 1]

| Structure | Crystallinity of $LiNbO_3$ | Propagation Loss [dB/cm] | Coupling Coefficient [%] |
|---|---|---|---|
| $LiNbO_3$/Diamond (110) | Polycrystalline | 93 | 1.1 |
| $LiNbO_3$/Diamond (331) | Polycrystalline | 86 | 1.2 |
| $LiNbO_3$/Diamond (112) | Polycrystalline | 97 | 1.1 |
| $LiNbO_3$/Diamond (111) | Monocrystalline | 72 | 2.5 |
| $LiNbO_3$/Diamond (100) | Monocrystalline | 76 | 1.4 |

As shown in the above Table 1, with respect to each of the SAW devices having the $LiNbO_3$/diamond (111) structure and $LiNbO_3$/diamond (100) structure, it was found that the propagation loss was decreased, and the electromechanical coupling coefficient was increased. The degree of the increase in electromechanical coupling coefficient of the SAW device having the $LiNbO_3$/diamond (111) structure was larger than that of the SAW device having the $LiNbO_3$/diamond (100) structure.

Example 6

An IDT having the same parameters as those used in Example 5 was formed on each of Ia-type natural diamonds and Ib-type high-pressure synthesized diamonds, respectively having (311), (110) and (111) plane orientations by using a Ti thin film (thickness: 500 Å). Then, an $LiNbO_3$ thin film (thickness: 1 μm) was formed on each of the thus formed IDTs by using RF magnetron sputtering.

<Conditions for LiNbO; Thin Film Formation>

Pressure: 0.01 Torr
Substrate Temperature: 620°C
Ar : $O_2$ = 1 : 2
RF Power: 80 W
Target: Li : Nb = 3 : 2 sintered product

Each of the resultant $LiNbO_3$ films was analyzed by using an X-ray diffraction apparatus to examine the c-axis orientational property thereof. As a result, with respect to the $LiNbO_3$ thin film formed on the monocrystalline diamond having the (111) orientation, no orientational property other than the c-axis orientation was observed. On the other hand, it was found that each of the $LiNbO_3$ thin films respectively formed on the (311) and (110) monocrystalline diamonds was a mixed film also having orientations other than the c-axis orientational property.

After the orientational property was evaluated in the above manner, a short-circuiting electrode (i.e., a solid electrode having the same occupation area as that of the IDT) was formed on each of the $LiNbO_3$ films by using an Al film (thickness: 500 Å), thereby to fabricate SAW devices. The propagation losses of these SAW devices before and after the formation of the IDT were measured in the same manner as in Example 5.

The results of measurement of the propagation losses are summarized in The following Table 2.

[Table 2]

| Substrate | Crystallinity | Propagation Loss [dB/cm] | Propagation Loss After short-Circuiting Electrode Formation [dB/cm] |
|---|---|---|---|
| Natural Ia (311) Diamond | Mixed film | 97 | 101 |
| Natural Ia (110) Diamond | Mixed film | 95 | 99 |
| Natural Ia (111) Diamond | C-axis orientation | 76 | 78 |
| High-Pressure Ib (311) Diamond | Mixed film | 96 | 100 |
| High-Pressure Ib (110) Diamond | Mixed film | 93 | 98 |
| High-Pressure Ib (111) Diamond | C-axis orientation | 73 | 76 |

As shown in above Table 2, it was found that the propagaticn loss was reduced in the SAW device having the $LiNbO_3$/diamond (111) structure.

Example 7

A diamond thin film was epitaxially grown on each of natural Ia-type monocrystalline diamond substrates and high-pressure synthesized Ib-type monocrystalline diamond substrates respectively having (100), (110) and (111) orientations, and on a surface of (100) Si and a surface of (111) β-SiC, and the surface of the resultant diamond film was polished and flattened in the same manner as in Example 3. Then, an $LiNbO_3$ film (thickness: 13,000 Å) was formed on each of the above diamond film surfaces under the same conditions as in Example 5.

A film of Al (thickness: 500 Å) was vapor-deposited on each of the $LiNbO_3$ films, and then subjected to photolithography to form an IDT which was the same as that used in Example 5, thereby to fabricate SAW device samples. With respect to the resultant SAW devices, the propagation losses and electromechanical coupling coefficients were measured in the same manner as in Example 5.

After the propagation losses were measured, an $SiO_2$ film (thickness: 3,000 Å) was formed on each of the above SAW device samples, and the propagation losses of these samples were measured. In addition, after the measurement of the propagation losses, a short-circuiting electrode (thickness: 500 Å) was formed on each of the above $SiO_2$ films by use of Al, and the propagation losses of the SAW devices were measured.

<Condition for Diamond Epitaxial Film Formation>

Microwave Plasma CVD

Diamond Film Formation on (100) and (110) faces

Power: 300 W
Pressure: 30 to 40 Torr
$CH_4/H_2 = 1$ to 6 (%)

(The diamond film was formed on the (111) face in the same manner as described above except that $CH_4/H_2 = 1$ to 2 (%).)

<Hetero-Epitaxial Conditions on Si and SiC>

Microwave Plasma CVD Method

Microwave Power: 900 W
Pressure: 10 to 3 mTorr
$CH_4/H_2 = 5/99.5$
Substrate Temperature: 800°C

(A DC bias of -150 V was applied to the substrate side).

<Condition for $SiO_2$ Formation>

RF Magnetron Sputtering Apparatus

Ar : $O_2$ = 1 : 1
Pressure: 0.02 Torr
RF Power: 200 W
$SiO_2$ Target
Thickness: 0.3 $\mu$m

With respect to the resultant SAW devices, the propagation losses were evaluated in the same manner as in Example 5. The results of the evaluation are summarized in The following Table 3.

[Table 3]

| Substrate | Crystallinity of LiNbO₃ | Propagation Loss [dB/cm] | Electromechanical Coupling Coefficient [%] |
|---|---|---|---|
| Natural Ia Diamond (100) | Monocrystal-line | 75 | 1.3 |
| Natural Ia Diamond (110) | Polycrystal-line | 94 | 1.2 |
| Natural Ia Diamond (111) | Monocrystal-line | 73 | 2.6 |
| High-Pressure Ib Diamond (100) | Monocrystal-line | 77 | 1.3 |
| High-Pressure Ib Diamond (110) | Polycrystal-line | 92 | 1.4 |
| High-Pressure Ib Diamond (111) | Monocrystal-line | 71 | 2.7 |
| Diamond (100)/Si (100) | Monocrystal-line | 91 | 1.1 |
| Diamond (111)/β-SiC (111) | Monocrystal-line | 84 | 2.2 |

| Substrate | Propagation Loss After SiO₂ Formation | Propagation Loss After Short-Circuiting Electrode Formation |
|---|---|---|
| Natural Ia Diamond (100) | 81 | 84 |
| Natural Ia Diamond (110) | 98 | 101 |
| Natural Ia Diamond (111) | 76 | 79 |
| High-Pressure Ib Diamond (100) | 81 | 85 |
| High-Pressure Ib Diamond (110) | 99 | 102 |
| High-Pressure Ib Diamond (111) | 75 | 79 |
| Diamond (100)/Si (100) | 96 | 99 |
| Diamond (111)/β-SiC (111) | 88 | 90 |

As shown in the above Table 3, it was found that the propagation losses were decreased in the SAW devices having the $LiNbO_3$/diamond (111) structure and $LiNbO_3$/diamond (100) structure. In addition, it was also found that the electromechanical coupling coefficient of the SAW device having the $LiNbO_3$/diamond (111) structure was increased.

Example 8

A (100) monocrystalline Si substrate was loaded in the reaction chamber of a hot filament-type CVD apparatus, and the reaction chamber was evacuated to $10^{-6}$ Torr or below. $CH_4$ and $H_2$ gases were supplied to the reaction chamber at a flow rate ratio $CH_4/H_2$ = 1 to 8%. The pressure of the reaction chamber was set to 100 to 200 Torr, and the filament temperature was set to 2,100°C. The temperature of the substrate surface was set to 950°C by adjusting the distance between the filament and the substrate. Under these conditions, a diamond film (thickness: 17 μm) was formed on the above monocrystalline Si substrate.

When the thus formed diamond film was evaluated by using an X-ray diffraction apparatus, it was found that the resultant diamond film was a polycrystalline diamond film wherein (100), (110) and (111) plane orientations were observed. At this time, various polycrystalline diamond films having different intensity ratios of the (111) or (220) plane could be formed by simultaneously changing the gas composition ratio and the pressure in the reaction chamber. In the X-ray diffraction analysis, since different peak intensities were observed on the basis of the respective planes, the peak intensity of the (111) plane was denoted by "100" to normalize the peak intensities based on the other planes.

Then,the resultant diamond/Si substrate was polished so as to provide a thickness of diamond of 15 μm after the polishing, and an IDT of Ti (thickness: 500 Å, the same electrode as in Example 5) and an $LiNbO_3$ film (thickness: 10,000 Å) were formed on the substrate in this order.

The resultant SAW devices were evaluated on the basis of the measurement of the propagation loss of SAW devices having IDTs respectively having different intervals between the electrode elements which had been formed in the same manner as in Example 5. The propagation losses were evaluated in the same manner as in Example 5.

The results of evaluation are shown in The following Table 4.

[Table 4]

|  | X-Ray Diffraction Intensity | | | Propagation Loss [dB/cm] |
| --- | --- | --- | --- | --- |
|  | (111) | (220) | (400) |  |
| No. 1 | 100 | 25 | 8 | 93 |
| No. 2 | 100 | 20 | 5 | 90 |
| No. 3 | 100 | 15 | 5 | 89 |
| No. 4 | 100 | 10 | 3 | 77 |
| No. 5 | 100 | 4 | 1 | 73 |
| No. 6 | 100 | 1 | 0 | 71 |
| No. 7 | 100 | 160 | 3 | 92 |

Example 9

In the same manner as in Example 8, a diamond thin film (thickness: 17 µm) was formed on a (100) monocrystalline Si substrate, the diamond film was polished so as to provide a diamond film thickness of 15 µm, an IDT of Ti (thickness: 500 Å, the same electrode as in Example 5) was formed on the diamond film, and an $LiNbO_3$ film (thickness: 10,000 Å) was formed on the IDT, thereby to fabricate a SAW device.

After the formation of the above $LiNbO_3$ film, the propagation loss of the resultant SAW device was measured in the same manner as in Example 5.

After the measurement of the propagation loss, a short-circuiting electrode (thickness: 500 Å) was formed on the above $LiNbO_3$ film by use of Al, and the propagation loss of the resultant SAW device was measured.

After the measurement of the propagation loss, a diamond-like carbon film (thickness: 400 Å) was formed on the surface of the above-mentioned short-circuiting electrode, and the propagation loss of the resultant SAW device was measured. At this time, the 400-Å thick diamond-like carbon film was formed in a manner such that methane gas was supplied to the reaction chamber at about 5 sccm, the pressure in the reaction chamber was maintained at about 0.002 Torr, the substrate temperature was set to 25°C, and discharge was conducted at a power density of 2 $W/cm^2$ so as to provide a plasma state for about 0.5 hour.

The results of measurement of the X-ray diffraction intensities and the propagation losses are summarized in the following Table 5.

[Table 5]

|  | X-Ray Diffraction Intensity | | | Propagation Loss After Short-Circulting Electrode Formation [dB/cm] | Propagation Loss After Diamond-Like Carbon Film Formation |
| --- | --- | --- | --- | --- | --- |
|  | (111) | (220) | (400) |  |  |
| No. 1 | 100 | 25 | 8 | 96 | 102 |
| No. 2 | 100 | 20 | 5 | 93 | 99 |
| No. 3 | 100 | 15 | 5 | 92 | 97 |
| No. 4 | 100 | 10 | 3 | 80 | 83 |
| No. 5 | 100 | 4 | 1 | 76 | 80 |
| No. 6 | 100 | 1 | 0 | 73 | 76 |
| No. 7 | 100 | 160 | 3 | 94 | 99 |

Example 10

A film of Al (thickness: 500 Å) was formed on each of Ia-type natural diamond substrates and Ib-type high-pressure synthesized diamond substrates, respectively having (311), (110) and (111) plane orientations, and then subjected to photolithography to provide an Al pattern as a negative or reversed pattern of IDT which could function as a mask.

Each of the above diamond substrates was set in an ion implantation apparatus, and B (boron) ions were implanted thereinto at an acceleration voltage of 120 keV and a dose of 4.5 x $10^{20}$ $cm^{-2}$.

After the ion implantation, the Al mask was removed, and the resultant product was annealed. The semiconducting diamond portion produced by the above-mentioned B ion implantation was caused to constitute an IDT (i.e.,

an IDT having the same parameters as those used in Example 5).

An LiNbO$_3$ film (thickness: 1 μm) was formed on the above IDT by using a liquid-phase growth method, and the propagation loss of the resultant SAW device was measured in the same manner as in Example 5.

<Condition for LiNbO$_3$ Film Formation>

Condition: Liquid-Phase Growth Method
Solution: 50 mol% LiO$_2$ + 40 mol% V$_2$O$_5$ + 10 mol% Nb$_2$O$_5$

(While the substrate was dipped in the solution, the substrate was heated to a temperature of 1,100°C, and then gradually cooled to 800°C.)

After the measurement of the propagation loss, a diamond thin film (thickness: 3,000 Å) was formed on the above LiNbO$_3$ film, and the propagation loss of the resultant SAW device was evaluated.

<Conditions for Diamond Thin Film Formation>

Apparatus: Microwave Plasma CVD Apparatus
Microwave Power: 350 W
Reaction Gas CH$_4$ : O$_2$ : H$_2$ = 0.5 : 1 : 98.5
Reaction Pressure: 30 Torr
Film Formation Temperature: 500°C
Film Thickness: 0.3 μm

The results of evaluation of the above propagation loss are summarized in The following Table 6.

[Table 6]

| Substrate | Propagation Loss [dB/cm] | Propagation Loss After Diamond Thin Film Formation [dB/cm] |
|---|---|---|
| Natural Ia (311) Monocrystalline | 96 | 104 |
| Natural Ia (110) Monocrystalline | 99 | 106 |
| Natural Ia (111) Monocrystalline | 77 | 83 |
| High-Pressure Ib (311) Monocrystalline | 90 | 97 |
| High-Pressure Ib (110) Monocrystalline | 92 | 100 |
| High-Pressure Ib (111) Monocrystalline | 73 | 81 |

Example 11

Ib-type high-pressure synthesized monocrystalline diamonds respectively having (311), (110) and (111) plane orientations were prepared, and an Al film (thickness: 500 Å) was vapor-deposited on each of the diamond surfaces. The Al film was then patterned into a negative or reversed pattern of IDT by using photolithography, thereby to form an Al mask. The resultant product was set in an RIE (Reactive Ion Etching) apparatus, and the diamond surface was etched, thereby to form grooves having a configuration corresponding to an IDT shape. At this time, the etching depth was 30 nm.

<RIE Conditions>

Ar : O$_2$ = 90 : 10
RF Power: 200 W
Pressure: 0.01 Torr

After the above RIE treatment, a resist film was formed on each of the resultant diamond surfaces and the resist film was patterned by using a photolithographic technique. The Al film was then removed to form grooves for providing an IDT on the diamond.

A film of Ti (thickness: 500 Å) was formed on each of the resultant substrates having the thus formed grooves, and the resist pattern was removed thereby to form an embedded-type IDT on the diamond.

An $LiNbO_3$ film (thickness: 10,000 Å) was formed on each of the resultant substrates having the above embedded-type IDT thereby to fabricate SAW devices. The propagation loss of each SAW device was measured.

After the measurement of the propagation loss, an $SiO_2$ film (thickness: 3,000 Å) was formed on the $LiNbO_3$ film constituting each of the above SAW devices, and the propagation loss of the resultant SAW device was measured.

After the measurement of the propagation loss, an Al short-circuiting electrode (thickness: 500 Å) was further formed on the $SiO_2$ film constituting each of the above SAW devices, and the propagation loss of the resultant SAW device was measured. At this time, the conditions for the formation of the $LiNbO_3$ film and the $SiO_2$ film were as follows.

\<$LiNbO_3$ Film\>

RF Magnetron Sputtering Apparatus

Gas: Ar : $O_2$ = 1 : 2
Pressure: 0.01 Torr
RF Power: 80 W
Substrate Temperature: 650°C
Target: Li : Nb = 3 : 2 sintered product

\<$SiO_2$ Film\>

RF Magnetron Sputtering Apparatus

Gas: Ar : $O_2$ = 1 : 1
Pressure: 0.01 Torr
RF Power: 250 W
Target: $SiO_2$
Film Thickness: 0.3 μm

The results of measurement of the above propagation loss are summarized in The following Table 7.

[Table 7]

| Substrate | Propagation Loss | Propagation Loss After $SiO_2$ Formation | Propagation Loss After Short-Circuiting Electrode Formation |
|---|---|---|---|
| Ib (311) | 94 | 101 | 104 |
| Ib (110) | 91 | 99 | 103 |
| Ib (111) | 73 | 81 | 84 |

Example 12

A (100) polycrystalline Si substrate was set in the reaction chamber of a plasma CVD apparatus, and the reaction chamber was evacuated to a vacuum of $10^{-6}$ Torr or below. $CH_4$ and $H_2$ gases were supplied to the reaction chamber at a flow rate ratio $CH_4/H_2$ = 1 to 8%. The pressure in the reaction chamber was set to 100 to 200 Torr, and the substrate temperature was set to 950° C. Under these conditions, a diamond film (thickness: 20μm) was formed on the above polycrystalline Si substrate.

When the resultant diamond film was evaluated by using an X-ray diffraction apparatus, it was found that the above diamond film was a polycrystalline film wherein (100), (110) and (111) plane orientations were observed. Polycrystalline diamond films having different intensity ratio of the (111) or (220) plane could be formed by simultaneously changing the gas composition ratio and the pressure in the reaction chamber. In the X-ray diffraction, different peak intensities were obtained with respect to different planes. Accordingly, the peak intensity based on the (111) plane was denoted by "100", and the peak intensities based on the other planes were normalized by using such a reference value.

Two substrates were provided with respect to each set of the conditions for the polycrystalline diamond formation. The surface of each of these two substrates was polished so as to provide a thickness of polished diamond film of 15 μm. Then, a Ti short-circuiting electrode (thickness: 500 Å) was formed on the polished diamond substrate, and an $LiNbO_3$ film (thickness: 10,000 Å) was formed on the short-circuiting electrode.

With respect to one sample of the above-mentioned two substrates, an IDT (i.e., an IDT having the same parameters as those used in Example 5) was formed on the substrate sample by use of Al, and the propagation loss of the resultant SAW device was evaluated. The conditions for $LiNbO_3$ film formation and the method of evaluating the propagation loss were the same as those used in Example 5.

After the measurement of the propagation loss, a diamond-like carbon film (thickness: 500 Å) was formed on the above SAW device in the same manner as in Example 9. The propagation loss of the resultant SAW device was measured in the same manner as in Example 9.

Separately, by use of the other sample of the above-mentioned two substrates, SAW devices were fabricated in the same manner as described above except that an $LiNbO_3$ film was formed on the substrate, a diamond-like carbon film was formed on the $LiNbO_3$ film, and thereafter an IDT was formed on the diamond-like carbon film. The propagation losses of the thus obtained SAW devices were measured in the same manner as described above. The results of measurement are shown in the following Table 8 (Table 8A and 8B).

[Table 8A]

|  | X-Ray Diffraction Intensity | | | Propagation Loss [dB/cm] |
|---|---|---|---|---|
|  | (111) | (220) | (400) |  |
| No. 1 | 100 | 25 | 8 | 102 |
| No. 2 | 100 | 25 | 8 | 101 |
| No. 3 | 100 | 19 | 6 | 99 |
| No. 4 | 100 | 17 | 6 | 90 |
| No. 5 | 100 | 11 | 3 | 81 |
| No. 6 | 100 | 13 | 2 | 83 |
| No. 7 | 100 | 1 | 0 | 75 |
| No. 8 | 100 | 1 | 0 | 76 |
| No. 9 | 100 | 181 | 4 | 94 |
| No. 10 | 100 | 172 | 5 | 99 |

[Table 8B]

|  | Propagation Loss After Electrode/Carbon Film Formation | Propagation Loss After Carbon Film/Electrode Formation |
|---|---|---|
| No. 1 | 109 |  |
| No. 2 |  | 110 |
| No. 3 | 106 |  |
| No. 4 |  | 108 |
| No. 5 | 88 |  |
| No. 6 |  | 92 |
| No. 7 | 83 |  |
| No. 8 |  | 85 |
| No. 9 | 102 |  |
| No. 10 |  | 106 |

Example 13

A diamond thin film (thickness: 20 μm) was epitaxially grown on each of high-pressure synthesized Ib-type monocrystalline diamond substrates having (311), (110) and (111) orientational property, and the surfaces of the diamond thin films were polished and flattened so as to provide a diamond film thickness of 15 μm. An $LiNbO_3$ film (thickness: 10,000 Å) was then formed on each of the polished diamond films. In the above-mentioned manner, three substrates were provided with respect to each of the plane orientations as described above. At this time, the epitaxial growth conditions for the diamond film and the conditions for $LiNbO_3$ film formation were the same as those used in Example 12.

with respect to a first one of the above-mentioned three substrates, an IDT (i.e., an IDT having the same parameters as those used in Example 5), an $SiO_2$ film (thickness: 3,000 Å), and a short-circuiting electrode (thickness: 500 Å) were formed on the $LiNbO_3$ film of each of the first substrates (respectively having the (311), (110) and (111) plane orientations) in this order, thereby to fabricate a SAW device $\underline{A}$. At this time, the $SiO_2$ film formation conditions were the same as those used in Example 11.

With respect to a second one of the above-mentioned three substrates, a SAW device was fabricated in the same manner as in the formation of the SAW device $\underline{A}$ except that an $SiO_2$ film and an IDT were formed on the $LiNbO_3$ film of each of the second substrates (respectively having the (311), (110) and (111) plane orientations) in this order, and a short-circuiting electrode was not formed.

With respect to the third one of the above-mentioned three substrates, a SAW device was fabricated in the same manner as in the formation of the SAW device $\underline{A}$ except that a short-circuiting electrode, an $SiO_2$ film and an IDT were formed on the $LiNbO_3$ film of each of the third substrates (respectively having the (311), (110) and (111) plane orientations) in this order.

The propagation loss of each of the thus obtained nine species of SAW devices was measured in the same manner as in Example 5. The results of measurement are summarized in the following Table 9 (Table 9A and 9B).

[Table 9A]

| Sample No. | Substrate | Propagation Loss of Short-Circuiting Electrode/$SiO_2$/IDT/Substrate |
|---|---|---|
| 1 | (311) | 95 |
| 2 | (311) | |
| 3 | (311) | |
| 4 | (110) | 89 |
| 5 | (110) | |
| 6 | (110) | |
| 7 | (111) | 79 |
| 8 | (111) | |
| 9 | (111) | |

[Table 9B]

| Sample No. | Propagation Loss of IDT/$SiO_2$/ Substrate | Propagation Loss of IDT/$SiO_2$/Short-Circuiting Electrode/Substrate |
|---|---|---|
| 1 | | |
| 2 | 93 | |
| 3 | | 99 |
| 4 | | |
| 5 | 90 | |
| 6 | | 93 |
| 7 | | |
| 8 | 78 | |
| 9 | | 82 |

Example 14

(Formation of Optical Waveguide)

An 8μm-thick $LiNbO_3$ (001) film was epitaxially grown on a surface of (111) high-pressure synthesized monocrystalline diamond. At this time, the $LiNbO_3$ (001) film was epitaxially grown in the same manner as in Example 5.

A 50nm-thick Ti film was formed on the above $LiNbO_3$ film by sputtering, and a resist film having a pattern reverse to that of an interferometric-type optical waveguide was formed by photolithography. Then, a portion of the resultant product for forming a waveguide was etched by using a solution obtained by diluting an etching solution comprising HF, $HNO_3$ and $H_2O$ (HF : $HNO_3$ : $H_2O$ = 1 : 1 : 50) by five times.

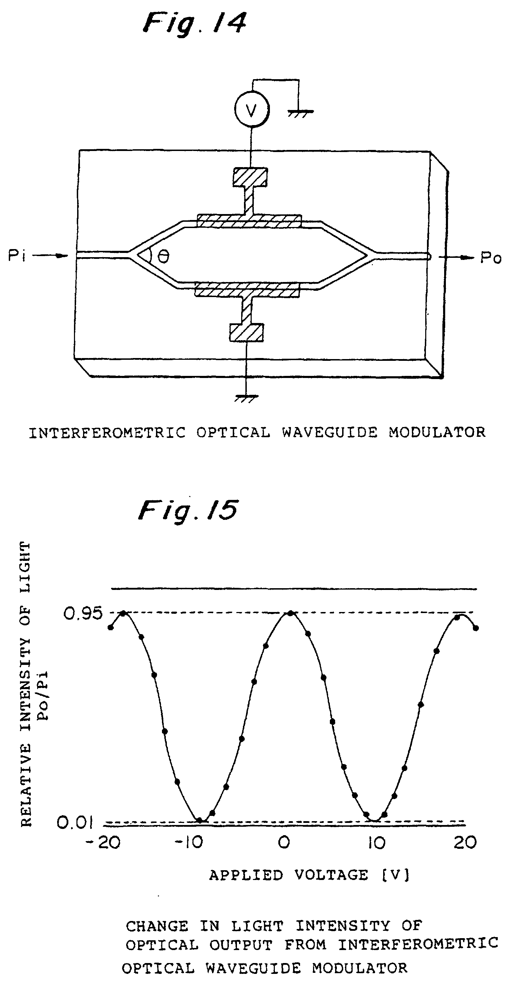

After the etching, the resultant multilayered (Ti/$LiNbO_3$/diamond) film was dipped in benzoic acid, and a proton exchange reaction was conducted at 240°C for 40 minutes. After the proton exchange reaction, Ti was removed to provide a branching-type optical waveguide having a slightly higher refractive index than the other portion in a predetermined portion of the $LiNbO_3$ film, thereby to obtain an interferometric-type optical waveguide as shown in the schematic plan view of Fig. 14.

The resultant change in refractive index of the above-mentioned portion (in terms of refractive index $\Delta n_e$ of extraordinary light provided by an InGaAsP laser having a wavelength of 1.2 $\mu$m) was 0.12 higher than the refractive index of extraordinary light in the bulk $LiNbO_3$. In other words, an optical waveguide was formed in the portion which had been subjected to the proton exchange reaction. When the propagation loss of the thus formed optical waveguide was measured by a prism coupling method (wherein a light beam was incident by use of a rutile prism), it was 2.5 dB/cm .

The above sample having an optical waveguide formed in the above-described manner was annealed in air at 400°C for 2 hours. The resultant optical waveguide had a refractive index $\Delta n_e$ of extraordinary light of 0.04 and a propagation loss of 0.8 dB/cm.

On the respective branched waveguides constituting the thus formed interferometric-type optical waveguide, electrodes for voltage application were formed by use of Al. The width of the voltage application electrode was 5 mm, the interval between the electrodes was 7 $\mu$m, and the electrode thickness was 50 nm.

An InGaAsP semiconductor laser (LD) was disposed on high-pressure synthesized Ib-type diamond, and thereafter an optical waveguide as described above was formed on a portion of the diamond adjacent to one end of the LD, and a thermistor was formed on another portion of the diamond adjacent to the other end of the LD, thereby to obtain an optical modulator as shown in the schematic sectional view of Fig. 8.

A change in output light from the thus formed optical modulator was investigated while changing a voltage to be applied to the optical modulator. The results of the investigation are shown in the graph of Fig. 15. In the graph of Fig. 15, the voltage is plotted as the abscissa, and a change (relative intensity) in output power in response to input power is plotted as the ordinate. As a result, it was found that the extinction ratio (i.e., the ratio of maximum output light to minimum output light) was 19.8 dB. Further, the voltage corresponding to a phase difference of $\pi$ between the two waveguide light components was 9.8 V.

For the purpose of comparison, a monolithic optical modulator was intended to be formed in the same manner as described above except that the (110) monocrystalline diamond face was used in place of the diamond (111) face, and an $LiNbO_3$ film was formed on the (110) diamond surface. However, a stable optical waveguide could not be formed since the $LiNbO_3$ film was partially etched in the proton exchange process. In one the thus obtained optical waveguides having a measurable level, the propagation loss of the annealed waveguide was as large as 6.8 dB/cm, and the extinction ratio was only 13.8 dB.

The detailed process for forming the monolithic optical modulator on the diamond (111) surface as described above was as follows.

(1) High-pressure synthesized Ib-type monocrystalline diamond (size: 1 cm x 1 cm x 30 $\mu$m) was provided. On the (111) face of the diamond, the diamond was subjected to etching by reactive ion etching (RIE) by use of Al as a mask, thereby to form an indentation or recessed portion (size: 300 x 350 x 70 $\mu$m) in which a semiconductor laser (LD) was to be disposed.

(2) An $SiO_2$ film (for selective etching of diamond) was formed on the diamond (111) surface by sputtering.
    \<RF Magnetron Sputtering\>

    Gas: Ar : $O_2$ = 1 : 1
    Pressure: 0.01 Torr
    RF Power: 250 W
    Target: $SiO_2$
    $SiO_2$ Film Thickness: 200 nm

(3) A portion corresponding to a portion of the diamond in which a thermistor was to be formed (hereinafter, referred to as "thermistor region") was etched by use of photolithography, and a surface portion of the diamond corresponding to the thermistor region was selectively exposed.

(4) A semiconducting diamond film was formed on the diamond surface corresponding to the thermistor region.
    Conditions: Microwave Plasma CVD Method

    $CH_4$ + $H_2$ = 1 : 100
    Doping Gas: $B_2H_6$ (100 ppm with respect to $CH_4$ gas)
    Pressure: 4 kPa
    Microwave Frequency: 2.45 GHz
    Power: 400 W
    Film Formation Period of Time: 1 hour

(5) The $SiO_2$ film was removed to selectively form the semiconducting diamond film on the thermistor region.

(6) An 8μm-thick $LiNbO_3$ film was epitaxially grown on a portion of the diamond (111) surface in which an optical modulator was to be formed (hereinafter, referred to as "optical modulator region"). At this time, the epitaxial growth conditions were the same as those used in Example 5.

(7) A 500mn-thick Ti film was formed on the $LiNbO_3$ by an electron beam vapor deposition method for the purpose of providing a mask to be used for the formation of an $LiNbO_3$ portion in which an optical waveguide was to be formed (hereinafter, referred to as "optical waveguide region").

(8) By use of photolithography, the Ti film corresponding to the optical modulator region was left while the remainder of the Ti film was removed by etching.

(9) The $LiNbO_3$ film was dry-etched by RIE by using the above-mentioned Ti film as a mask.

(10) The above Ti film was removed to provide an $LiNbO_3$ film corresponding to the optical modulator region.

(11) A film of Ti (thickness: 100 nm) was formed on the $LiNbO_3$ film by an electron beam vapor deposition method.

(12) A pattern reversed to an interferometric optical waveguide pattern was formed in the Ti film by photolithography.

(13) The resultant product was subjected to etching by using the above Ti film as a mask and an etching solution which had been obtained by diluting an etching solution of HF : $HNO_3$ : $H_2O$ = 1 : 1 : 50 by five times.

(14) The resultant Ti/$LiNbO_3$/diamond multilayer substrate was dipped in benzoic acid, and a proton exchange reaction was conducted at 240 °C for 40 minutes.

(15) The Ti film was removed to form an optical waveguide. At this time, the refractive index was measured. As a result, the refractive index $\Delta n_e$ of extraordinary light at the waveguide formed by the proton exchange reaction was 0.12 higher than that of the remainder bulk $LiNbO_3$ portion. The propagation loss was 2.4 dB/cm.

(16) The above optical waveguide was annealed in air at 400°C for 2 hours. As a result, the refractive index $\Delta n_e$ of extraordinary light at the waveguide became higher than the remainder bulk $LiNbO_3$ portion by 0.04. The propagation loss was reduced to 0.8 dB/cm.

(17) Electrodes of Al for controlling the guided light (electrode width: 5 mm; interval between electrode elements: 10 μm; electrode thickness: 50 nm) were respectively formed on the waveguides by using photolithography and ion plating.

(18) By use of an electron beam vapor deposition method, a Ti film (film thickness: 50 nm) was formed on a surface opposite to the monocrystalline diamond substrate surface on which the above waveguide had been formed. A 1-5μm-thick Au film was vapor-deposited on the Ti film.

(19) A 50-nm thick Ti film was vapor-deposited on the thermistor region (two portions) on the surface of the monocrystalline diamond substrate on which the waveguides had been formed, and on a portion in which a semiconductor laser was to be disposed (hereinafter, referred to as "semiconductor laser region"), by using a metal mask. In addition, on the thermistor region, an Mo film (thickness: 100 nm) and an Au film (thickness: 200 nm) were sequentially formed in this order thereby to form ohmic electrodes. On the semiconductor laser region, a 1.5μm-thick Au film was formed on the above Ti film. The thus formed diamond thermistors were subjected to wire bonding by use of a gold wire.

(20) The metal coating surface (i.e., a surface vapor-deposited with Ti/Au) of the monocrystalline diamond substrate was bonded to a gold-plated copper substrate by using Au-Sn solder.

(21) A 1.3-μm InGaAsP laser was bonded to the semiconductor laser region of the monocrystalline diamond substrate by using Au-Sn solder in the same manner as described above.

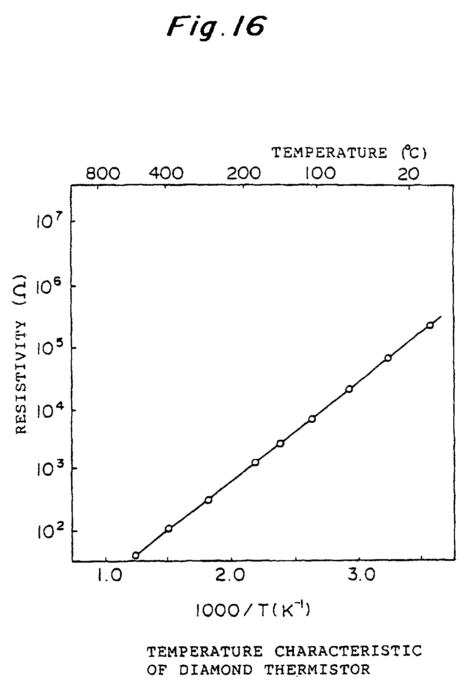

The resistivity of a thermistor (singly located) formed in the same manner as in the formation of the above diamond thermistor was measured while changing the substrate temperature from room temperature to 600° C. As shown in the temperature characteristic graph of Fig. 16, it was confirmed that the resistivity was changed linearly with respect to the temperature.

As described hereinabove, in the present invention, a film of $LiNbO_3$ having a function as a piezoelectric substance is formed on a surface of monocrystalline or polycrystalline diamond having a specific orientational property of (111) or (100), and therefore a higher c-axis (or a-axis) orientational property than that of the same substance formed on diamond surfaces having the other orientations.

In addition, according to the present invention, good crystallinity may be provided on the basis of the above-mentioned orientational property, and the surface roughness of the resultant $LiNbO_3$ film can also be reduced. Accordingly, it is possible to provide an orientational material or substrate which may suitably be used as an element or component for forming a variety of dynamical, electric, electronic, and/or optical devices.

When a SAW device is constituted by using the orientational material or substrate according to the present invention, there may be provided a SAW device which is capable of being operated while effectively reducing the propagation loss of SAW.

The basic foreign Application filed on May 27, 1994, No. 115538/1994 (i.e., Hei 6-115538) in JAPAN is hereby incorporated by reference.

In addition, "Diamond Thin Film", written by Tadao Inuzuka, pp. 99-115, 1990, published by Kyoritsu Shuppan (Tokyo, JAPAN) is hereby incorporated by reference.

Many modifications of the present invention may be made without departing from the essential scope thereof. It should be understood that the present invention is not limited to the specific embodiments as described.

From the invention thus described, it will be obvious that the invention may be varied in many ways. Such variations are not to be regarded as a departure from the scope of the invention, and all such modifications as would be obvious to one skilled in the art are intended to be included within the scope of the following claims.

The basic Japanese Application Nos.79883/1994 filed on March 25, 1994 and 115538/1994 filed on May 27, 1994 are hereby mentioned.

## Claims

1. A material comprising:

   monocrystalline diamond, and a $LiNbO_3$ film disposed on a surface of specific orientational diamond of (100) provided by the diamond, wherein the (100) plane of the $LiNbO_3$ film is parallel to the (100) plane of the monocrystalline diamond.

2. A material according to claim 1, which comprises:

   monocrystalline diamond, and an $LiNbO_3$ film disposed on a surface of (100) orientational diamond provided by the monocrystalline diamond, the (100) plane of said $LiNbO_3$ film being parallel to the (100) plane of said monocrystalline diamond.

3. A material according to claim 2, wherein the monocrystalline diamond comprises natural diamond or high-pressure synthesized diamond.

4. A material according to claim 2, wherein the monocrystalline diamond for providing the surface of (100) orientational diamond comprises a diamond film which has been epitaxially grown on a (100) surface of another monocrystalline diamond.

5. A material according to claim 2, wherein the monocrystalline diamond for providing the surface of (100) orientational diamond comprises a hetero-epitaxially grown diamond film.

## Patentansprüche

1. Material, umfassend:

   monokristallinen Diamant, und einen $LiNbO_3$-Film, der auf einer spezifischen, (100)-orientierten, durch den Diamant bereitgestellten Diamantoberfläche angeordnet ist, wobei die (100)-Ebene des $LiNbO_3$-Films parallel zur (100)-Ebene des monokristallinen Diamants verläuft.

2. Material nach Anspruch 1, das folgendes aufweist:

   monokristallinen Diamant, und einen $LiNbO_3$-Film, der auf einer (100)-orientierten, durch den monokristallinen Diamant bereitgestellten Diamantoberfläche angeordnet ist, wobei die (100)-Ebene des $LiNbO_3$-Films parallel zur (100)-Ebene des monokristallinen Diarnants verläuft.

3. Material nach Anspruch 2, bei dem der monokristalline Diamant natürlichen Diamant oder durch Hochdruck synthetisierten Diamant umfasst.

4. Material nach Anspruch 2, bei dem der monokristalline Diamant zur Bereitstellung der (100) orientierten Diamantoberfläche einen Diamantfilm umfasst, der epitaktisch auf der (100)-Oberfläche eines anderen monokristallinen Diamants aufgewachsen ist.

5. Material nach Anspruch 2, bei dem der monokristalline Diamant zur Bereitstellung der (100) orientierten Diamantoberfläche einen hetero-epitaktisch aufgewachsenen Diamantfilm umfasst.

**Revendications**

1.  Matériau comprenant :

    un diamant monocristallin, et un film $LiNbO_3$ disposé sur une surface de diamant à orientation spécifique de (100) fournie par le diamant, dans lequel le plan (100) du film $LiNbO_3$ est parallèle au plan (100) du diamant monocristallin.

2.  Matériau selon la revendication 1, qui comprend :

    un diamant monocristallin, et un film $LiNbO_3$ disposé sur une surface de (100) diamant à orientation par le diamant monocristallin, le plan (100) dudit film $LiNbO_3$ étant parallèle au plan (100) dudit diamant monocristallin.

3.  Matériau selon la revendication 2, dans lequel le diamant monocristallin comprend un diamant naturel ou un diamant synthétisé sous haute pression.

4.  Matériau selon la revendication 2, dans lequel le diamant monocristallin dessiné à fournir la surface de diamant à orientation (100) comprend un film de diamant qui a été mis en croissance épitaxiale sur une surface (100) d'un autre diamant cristallin.

5.  Matériau selon la revendication 2, dans lequel le diamant monocristallin destiné à fournir la surface de diamant à orientation (100) comprend un film de diamant mis en croissance hétéro-épitaxiale.

## Fig. 1

LiNbO$_3$

INTERDIGITAL TRANSDUCER

DIAMOND

(ELECTRODE ARRANGEMENT A)

## Fig. 2

SHORT-CIRCUITING ELECTRODE

LiNbO$_3$

INTERDIGITAL TRANSDUCER

DIAMOND

(ELECTRODE ARRANGEMENT C)

28

## Fig. 3

INTERDIGITAL TRANSDUCER

LiNbO₃

DIAMOND

(ELECTRODE ARRANGEMENT E)

## Fig. 4

INTERDIGITAL TRANSDUCER

LiNbO₃

DIAMOND

(ELECTRODE ARRANGEMENT F)

## *Fig. 5*

ELECTRODE ELEMENT INTERSECTION WIDTH:w

ELECTRODE ELEMENT WIDTH:d

## *Fig. 6*

## *Fig.7*

RAMAN SHIFT (cm⁻¹)

RAMAN SPECTRA OF VARIOUS PHASES OF CARBON

(a) AMORPHOUS CARBON.   (b) GRAPHITE.
(c) DIAMOND.

# Fig. 8

DIAMOND
THERMISTOR        LD        OPTICAL MODULATOR

Ti/Mo/Au ELECTRODE        SEMICONDUCTING        MODULATION ELECTRODE
                          DIAMOND
                                                                    OPTICAL
                                                                    WAVEGUIDE

                                                                    LiNbO₃

                                                        MONOCRYSTALLING
                                                        DIAMOND

                    Ti/Au  ELECTRODE
        ELECTRODE

# Fig. 9

INTENSITY (RELATIVE VALUE)

LiNbO₃(006)    DIAMOND(111)

20        30        40

2θ (deg)

## Fig. 10

ELECTRON BEAM INCIDENT DIRECTION

Fig. 11

# Fig.12

Fig.13

# Fig. 14

INTERFEROMETRIC OPTICAL WAVEGUIDE MODULATOR

# Fig. 15

CHANGE IN LIGHT INTENSITY OF
OPTICAL OUTPUT FROM INTERFEROMETRIC
OPTICAL WAVEGUIDE MODULATOR

# Fig.16

TEMPERATURE CHARACTERISTIC
OF DIAMOND THERMISTOR